# EUROPÄISCHE PATENTSCHRIFT

(11) **EP 2 471 151 B1**
(45) Veröffentlichungstag und Bekanntmachung des Hinweises auf die Patenterteilung: **19.02.2020**
(21) Anmeldenummer: 10740685.2
(22) Anmeldetag: 11.08.2010
(51) Int. Cl.: H01S 5/028, H01S 5/20, H01S 5/00, H01S 5/026

(54) **HALBLEITERLASER MIT AUF EINEM LASERSPIEGEL ANGEBRACHTEM ABSORBER**
SEMICONDUCTCOR LASER HAVING AN ABSORBER ATTACHED TO A LASER MIRROR
LASER Ä SEMI-CONDUCTEUR AVEC UN ABSORBEUR FIXÉ SUR UN MIROIR LASER

(30) Priorität: 26.08.2009 DE 102009028909
(43) Veröffentlichungstag der Anmeldung: 04.07.2012
(73) Patentinhaber: nanoplus Nanosystems and Technologies GmbH, 97218 Gerbrunn (DE)
(72) Erfinder: KOETH, Johannes Bernhard, 97218 Gerbrunn (DE)
(74) Vertreter: Wegner, Hans
(86) Internationale Anmeldenummer: PCT/EP2010/061687
(87) Internationale Veröffentlichungsnummer: WO 2011/023551

(56) Entgegenhaltungen:
- EP-A2- 1 137 134
- WO-A1-2009/080012
- DE-A1- 19 908 426
- FR-A1- 2 753 794
- JP-A- 55 043 822
- JP-A- 2001 133 403
- JP-A- 2003 133 648
- US-A- 4 503 541
- US-A1- 2008 309 218

## Beschreibung

### 1. Technisches Gebiet

Die vorliegende Erfindung betrifft einen Halbleiterlaser mit auf einem Laserspiegel angebrachtem Absorber zur Unterdrückung der durch den Laserspiegel hindurch emittierten Strahlung.

### 2. Stand der Technik

Halbleiterlaser spielen bereits heute in vielen Wirtschaftsbereichen als kohärente Lichtquellen mit hohem Wirkungsgrad eine wichtige Rolle. Sie finden beispielsweise im Telekommunikationsbereich und in dem Gebiet der Sensorik Anwendung.

Normalerweise emittieren Halbleiterlaser aufgrund ihres Aufbaus Licht über zwei Spaltflächen des Halbleiterkristalls, die als Laserspiegel wirken. In aller Regel wird jedoch nur die über einen Laserspiegel ausgekoppelte Strahlung mit Hilfe optischer Elemente zur weiteren Verwendung gesammelt. Dieses nutzbare Licht wird in der Regel durch den frontseitigen Laserspiegel abgestrahlt. Die durch den rückseitigen Laserspiegel emittierte Strahlung stellt eine Verlustquelle dar, die den Wirkungsgrad der Strahlungsquelle begrenzt. Um diesen Verlust möglichst klein zu halten, wird häufig der rückseitige Laserspiegel zusätzlich verspiegelt. Doch selbst eine rückseitig verspiegelte Laserdiode strahlt noch immer zumindest einige Prozent der nutzbaren Lichtleistung durch den rückseitigen Laserspiegel ab.

Die US 2008/0309218 A1 offenbart einen Licht absorbierenden Beschichtungsfilm, der auf der äußersten Oberfläche der Licht emittierenden Seite eines Chips angebracht ist, der als eine Laserdiode benutzt wird, normalerweise als ein Laserchip und der einen Teil des emittierten Lichts absorbiert. Durch das Bilden dieses Licht absorbierenden Beschichtungsfilms wird das Ansammeln und Anreichern von Verunreinigungen, das durch Reagieren mit dem emittierten Licht verursacht wird, eingeschränkt.

Die WO 2009/080012 A1 beschreibt eine Laserlichtquelle, die insbesondere eine Halbleiterschichtenfolge mit einem aktiven Bereich und einer Strahlungsauskoppelfläche mit einem ersten Teilbereich und einem davon verschiedenen zweiten Teilbereich und eine Filterstruktur aufweist, wobei der aktive Bereich im Betrieb kohärente erste elektromagnetische Strahlung mit einem ersten Wellenlängenbereich und inkohärente zweite elektromagnetische Strahlung mit einem zweiten Wellenlängenbereich erzeugt, die kohärente erste elektromagnetische Strahlung entlang einer Abstrahlrichtung vom ersten Teilbereich abgestrahlt wird, die inkohärente zweite elektromagnetische Strahlung vom ersten Teilbereich und vom zweiten Teilbereich abgestrahlt wird, der zweite Wellenlängenbereich den ersten Wellenlängenbereich umfasst und die Filterstruktur die vom aktiven Bereich abgestrahlte inkohärente zweite elektromagnetische Strahlung entlang der Abstrahlrichtung zumindest teilweise abschwächt.

Die US Patentschrift mit der Nr. 4 503 541 offenbart eine Vorrichtung zum Kontrollieren der Linienbreite eines Halbleiterlasers, indem ein Teil des emittierten Lichts in die den LaserResonator zurückreflektiert wird. Dazu wird die aktive Schicht eines Halbleiterlasers mit einer elektroabsorptiven Zelle auf einem gemeinsamen Substrat ausgerichtet. Das in der aktiven Schicht erzeugte Licht durchläuft die aktive Schicht der elektroabsorptiven Zelle, deren Lichtabsorption durch elektronisch kontrolliert wird und wird dann in einen - Wellenleiter eingekoppelt von dessen reflektierenden Ende durchläuft das Licht den umgekehrten Weg zurück in die aktive Schicht des Halbleiterlasers.

Die JP 55043822 A beschreibt eine Licht absorbierende Schicht auf einer Laserfacette, die zwischen zwei Siliziumdioxidschichten eingebettet ist. Die Licht absorbierende Schicht verringert die spektrale Breite des Verstärkungsspektrums, ohne dass die Stromdichte an der Laserschwelle ansteigt.

Die Offenlegungsschrift DE 199 08 426 A1 beschreibt eine Vertikalresonator-Laserdiode bei der zwischen einer ersten Bragg-Reflektor-Schichtenfolge und einer zweiten Bragg-Reflektor-Schichtenfolge, eine aktive Schichtenfolge zur Erzeugung von Laserstrahlung angeordnet ist. Eine der beiden Bragg-Reflektor-Schichtenfolgen ist für die in der aktiven Schichtenfolge erzeugte Laserstrahlung teildurchlässig und mindestens eine Licht absorbierende Schicht mit einer definierten Lichtabsorption ist zwischen der teildurchlässigen Bragg-Reflektor-Schichtenfolge und einer entsprechenden Kontaktschicht oder auf der Lichtaustrittsseite der elektrischen Kontaktschicht angeordnet.

Die JP 2003 133648 A auf eine Nitrid-Halbleiterlaserdiode, auf der auf einer Laserfacette eine Absorptionsschicht aus n-dotiertem AlGa₍₁₋ₓ₎N aufgebracht ist. Die Bandlücke der Absorptionsschicht wird so eingestellt, dass sie spontane Emission absorbiert und so das Rauschen, insbesondere das optische Rauschen der Nitrid-Halbleiterlaserdiode verringert.

Die US 2009/0129427 A1 offenbart ein optisches Modul, das eine Laserlichtquelle, ein optisches Verzweigungselement zum Empfangen von Laserlicht von der Laserlichtquelle aufweist. Das optische Verzweigungselement bewirkt, dass ein Teil des Laserlichts durch das optische Verzweigungselement hindurchtritt und ein verbleibender Teil abgezweigt wird. Ein photodetektierender Teil empfängt den verbleibenden Teil des Laserlichts, das von dem optischen Verzweigungselement abgezweigt wird. Ein Gehäuse beinhaltet die Laserlichtquelle, das optische Verzweigungselement und den photodetektierenden Teil, wobei das Gehäuse in seinem Inneren Streulicht reduzierende Elemente bereitstellt, um Streulicht zu reduzieren, das innerhalb des Gehäuses erzeugt wird.

Die WO 97/08793 bezieht sich auf eine Laservorrichtung mit einer Vielzahl von in einem laseraktiven Bereich angeordneten Einzellasern innerhalb von äußeren Begrenzungsflächen mit quer zur Austrittsrichtung des Laserlichts verlaufenden vorderen und hinteren Begrenzungsflächen und parallel zur Austrittsrichtung des Laserlichts verlaufenden seitlichen, sowie unteren und oberen Begrenzungsflächen. Mehrere, vorzugsweise sämtliche der äußeren Begrenzungsflächen der Laservorrichtung sind wenigstens annähernd vollständig mit der Absorptionssicht versehen. Des Weiteren weist die Absorptionsschicht ein für das Laserlicht reflexionsverminderndes und/oder absorptives und/oder gegenüber dem Material des laseraktiven Bereichs brechungsindexangepasstes Material auf.

Die JP 58 016 586 A offenbart eine Anordnung einer Laserdiode mit der verhindert werden soll, dass der rückseitige Strahl sich zu dem frontseitig abgestrahlten Strahl hinzumischt. Dazu wird der durch den rückseitigen Laserspiegel abgestrahlte Laserstrahl von einer Glasfaser gesammelt und in einem Dispersionsabschwächungsteil an deren anderem Ende durch Dispersion abgeschwächt.

Die EP 1 137 134 A2 beschreibt eine monolithische zwei Wellenlängen emittierende Halbleiter-Laser-Vorrichtung, die eine frontseitige Beschichtung auf einer Stirnfläche eines Resonators und eine hochreflektierende Stirnfläche in Form einer mehrschichtigen Beschichtung auf der rückseitigen Stirnfläche aufweist. Die frontseitige Beschichtung wird unter Verwendung eines Materials mit niedrigem Brechungsindex ausgeführt und die Schichtdicke wird so eingestellt, dass die Reflektivität 20% beträgt. Die hochreflektierende Stirnflächenbeschichtung wird durch alternierende Stapelung dünner Schichten aus Material mit niedrigem und hohem Brechungsindex gebildet und die Schichtdicke wird so eingestellt, dass die Reflektivität 80% beträgt. Die Schichtdicke jeder dieser beiden Stirnflächenbeschichtungen wird für eine optische Länge d = (1/4 + j) x λₘ unter Verwendung eines Mittelwertes λₘ = (λ₁ + X2) der Schwingungswellenlängen der beiden Halbleiter-Laserdioden berechnet. Dadurch wird es möglich, Stirnflächenbeschichten zu erhalten, die eine gewünschte Reflektivität aufweisen und die in einem Schritt gebildet werden können und eine Halbleiter-Laser-Vorrichtung mit zwei Emissionswellenlängen herzustellen, die eine große Zuverlässigkeit aufweist, das geforderte Betriebsverhalten erfüllt und eine große Produktivität aufweist

Halbleiterlaser sind in der Regel so in ein Gehäuse eingebaut, dass der frontseitige Laserspiegel dem zur Abbildung der optischen Strahlung verwendeten optischen Element zugewandt ist. Der rückseitige Laserspiegel zeigt hingegen sehr häufig in Richtung eines oder mehrerer Gehäuseteile. Die durch den rückseitigen Laserspiegel die Laserdiode verlassenden Photonen werden zumindest teilweise von den Gehäuseteilen reflektiert. Über Mehrfachflexionen kann ein Teil des durch den rückseitigen Laserspiegel emittierten Lichts in das abbildende optische Element gelangen, das das frontseitig emittierte Licht sammelt. Die Einkopplung dieses Streulichts in die nutzbare optische Strahlung verschlechtert de-ren Kohärenzeigenschaften und führt bei moduliert betriebenen Laserdioden zu einer unkontrollierbaren zeitlichen Schwankung der Lichtintensität und bei mit konstantem Injektionsstrom betriebenen Laserdioden zu einem Versatz in der optischen Ausgangslichtleistung.

Im Sensorikbereich insbesondere in der Gassensorik müssen kleinste Konzentrationen oder Spuren eines Moleküls im ppm-Bereich (parts per million) in der Atmosphäre zuverlässig nachweisbar sein. Die abstimmbare Laserdioden-Spektroskopie (TDLS, tunable diode laser spectroscopy) kann hier erfolgreich eingesetzt werden. Eine essentielle Voraussetzung für den Einsatz der TDLS ist, dass Laserdioden hergestellt werden können, die im Wesentlichen Licht einer einzigen Eigenschwingung des Laserresonators emittieren. Der Nachweis der verschiedenen Moleküle geschieht bei der TDLS durch Anregung von für jedes Molekül charakteristischen Rotationsschwingungsübergängen mit Hilfe von Laserdioden. Die Anregung der Rotationsschwingungsübergänge entzieht dem Lichtstrahl einzelne Photonen bei der charakteristischen Frequenz des Molekülübergangs. Damit ergeben sich zwei weitere wichtige Vorraussetzungen für den Einsatz von Laserdioden im Bereich der Gassensorik: Die Linienbreite des anregenden Halbleiterlasers muss sehr schmal sein, d.h. vergleichbar mit der Linienbreite der Rotationsschwingungsübergänge der nachzuweisenden Moleküle. Zudem muss die Emissionswellenlänge exakt auf den Übergang oder die Übergänge abgestimmt werden können und definiert über den Übergang oder die Übergänge durchgestimmt werden können. Wie in der Patentschrift EP 0 985 535 B1 offenbart, erfüllen DFB (distributed feedback) Laserdioden mit lateraler Kopplung alle oben genannten Voraussetzungen.

Das unkontrollierte Einkoppeln von Streulicht in den Lichtstrahl des frontseitigen Laserspiegels kann jedoch die Qualität des Nutzsignals zum Nachweis geringster Konzentrationen eines Moleküls verschlechtern und kann dadurch die Nachweisempfindlichkeit einer Sensorvorrichtung, die als Lichtquelle eine DFB Laserdiode aufweist, empfindlich beeinträchtigen.

Der vorliegenden Erfindung liegt daher das Problem zu Grunde, Maßnahmen anzugeben, die verhindern, dass durch den rückseitigen Laserspiegel emittierte Strahlung als Streulicht in den nutzbaren Lichtstrahl eingekoppelt wird.

### 3. Zusammenfassung der Erfindung

Gemäß einem Ausführungsbeispiel der vorliegenden Erfindung wird dieses Problem durch eine Vorrichtung nach Anspruch 1 gelöst. In einer Ausführungsform umfasst die Vorrichtung einen Halbleiterlaser, der zumindest ein Halbleitersubstrat, zumindest eine auf dem Halbleitersubstrat angeordnete aktive Schicht und zumindest einen Laserspiegel aufweist, der an einem Ende der aktiven Schicht angeordnet ist und durch den ein Teil der in der aktiven Schicht erzeugten Strahlung austritt, wobei der Laserspiegel mit einer Schicht absorbierenden Materials versehen ist, die geeignet ist, eine Steigung der Lichtleistungs-Strom-Kennlinie für Strahlung, die durch den Laserspiegel austritt, zu verringern.

Gemäß einem weiteren Ausführungsbeispiel der vorliegenden Erfindung wird dieses Problem durch eine Vorrichtung nach Anspruch 2 gelöst. In einer weiteren Ausführungsform umfasst die Vorrichtung einen Halbleiterlaser, der zumindest ein Halbleitersubstrat, zumindest eine auf dem Halbleitersubstrat angeordnete aktive Schicht und zumindest einen Laserspiegel aufweist, der an einem Ende der aktiven Schicht angeordnet ist und durch den ein Teil der in der aktiven Schicht erzeugten Strahlung austritt, und ein auf dem Halbleitersubstrat angeordnetes Absorbermodul, das in einem Abstand von dem Laserspiegel in Richtung der erzeugten Strahlung angeordnet ist und das geeignet ist hinter dem Absorbermodul eine Steigung der Lichtleistungs-Strom-Kennlinie für Strahlung, die durch den Laserspiegel austritt, zu verringern.

Die Schicht absorbierenden Materials auf dem rückseitigen Laserspiegel und / oder das Absorbermodul absorbieren Strahlung nach deren Durchtritt durch den rückseitigen Laserspiegel und setzen sie in Wärme um. Nur noch wenige Photonen können diese Absorberschicht und / oder das Absorbermodul verlassen und auf die rückwärtigen Gehäuseteile gelangen. Die Zahl der Photonen, die als Streulicht tatsächlich in den nutzbaren Lichtstrahl eingekoppelt wird, ist vernachlässigbar. Eine Verschlechterung der Kohärenzeigenschaften des genutzten Lichtstrahls durch Streulicht, das von dem rückseitigen Laserspiegel herrührt, unterbleibt. Anwendungen im Sensorikbereich werden durch eine Verschlechterung der Strahlqualität des Nutzsignals nicht länger in ihrer Nachweisempfindlichkeit beeinträchtigt.

Ferner ist die Anordnung des Absorbermoduls auf dem Halbleitersubstrat nicht zwingend. Es ist auch denkbar das Absorbermodul an einem Teil oder an verschiedenen Teilen des Gehäuses anzubringen, beispielsweise auf der Trägerplatte der Laserdiode.

In einer weiteren bevorzugten Ausführungsform umfasst die Schicht absorbierenden Materials und / oder das Absorbermodul ein oder mehrere Halbleitermaterialien und / oder Halbleiterverbindungen, die in dem Wellenlängenbereich der erzeugten Strahlung absorbieren, Kohlenstoff oder Kohlenstoffverbindungen und / oder eine oder mehrere Farben oder einen oder mehre Lacke.

In einer besonders bevorzugten Ausführungsform ist zwischen dem Laserspiegel und der Schicht absorbierenden Materials zumindest eine elektrische Isolationsschicht angeordnet.

In einer ganz besonders bevorzugten Ausführungsform umfasst die Schicht absorbierenden Materials ein oder mehrere Metalle, insbesondere Titan. In einer weiteren ganz besonders bevorzugen Ausführungsform umfasst das Absorbermodul ein oder mehrere Metalle, insbesondere Titan.

In einer weiteren bevorzugten Ausführungsform umfasst die dielektrische Reflexionsschicht zumindest ein Metalloxid, wie beispielsweise Aluminiumoxid, Magnesiumoxid und /oder Titanoxid. Ferner umfasst in einer weiteren bevorzugten Ausführungsform die Reflexionsschicht zumindest ein Halbleitermaterial, beispielsweise Silizium, eine Halbleiterverbindung, beispielsweise Siliziumdioxid und / oder eine Schichtstruktur aus einem Halbleitermaterial und einer Halbleiterverbindung.

In einer bevorzugten Ausführungsform ist zwischen dem Laserspiegel und der Reflexionsschicht zumindest eine elektrische Isolationsschicht angeordnet ist. In einer weiteren bevorzugten Ausführungsform ist zwischen dem Laserspiegel und der elektrischen Isolationsschicht eine Reflexionsschicht angeordnet.

In noch einer weiteren bevorzugten Ausführungsform ist zwischen der Reflexionsschicht und der Schicht absorbierenden Materials zumindest eine elektrische Isolationsschicht angeordnet.

In einer weiteren bevorzugten Ausführungsform umfasst eine Reflexionsschicht zumindest ein Metall, insbesondere Gold oder Silber.

In einer weiteren Ausführungsform weist das Absorbermodul, das in einem Abstand hinter dem Laserspiegel angeordnet ist, eine Fläche senkrecht zum Lichtstrahl auf, auf die zumindest 99,9 % der durch den Laserspiegel austretenden Lichtintensität trifft.

In einer bevorzugten Ausführungsform ist das Absorbermodul an zumindest einer Seite, die dem Laserspiegel zugewandt ist, mit einer Schicht absorbierenden Materials versehen. In einer weiteren bevorzugten Ausführungsform ist die gesamte Oberfläche des Absorbermoduls mit einer Schicht absorbierenden Materials versehen.

Ferner wird in einer bevorzugten Ausführungsform das Absorbermodul mittels eines Epitaxieprozesses auf dem Halbleitersubstrat hergestellt. In einer weiteren bevorzugten Ausführungsform wird das Absorbermodul durch Kleben oder Löten auf dem Halbleitersubstrat befestigt.

In einer ganz besonders bevorzugten Ausführungsform weist eine Sensorvorrichtung zum Bestimmen von Gaskonzentrationen einen Halbleiterlaser gemäß einer der vorangehenden Ausführungsformen auf.

### 4. Beschreibung der Zeichnungen

In der folgenden detaillierten Beschreibung werden derzeit bevorzugte Ausführungsbeispiele der Erfindung unter Bezugnahme auf die Zeichnungen beschrieben, wobei
- Fig. 1: eine schematische Darstellung der für die Erfindung wichtigsten Komponenten eines Halbleiterlasers zeigt, wobei der Halbleiterlaser eine Schicht absorbierenden Materials auf dem rückseitigen Laserspiegel aufweist;
- Fig. 2: eine schematische Darstellung der für die Erfindung wichtigsten Komponenten eines Halbleiterlasers zeigt, wobei ein Absorbermodul auf dem Halbleitersubstrat in einem Abstand von dem rückseitigen Laserspiegel angeordnet ist;
- Fig. 3: die Fig.1 mit einer elektrischen Isolationsschicht zwischen dem rückseitigen Laserspiegel und der Schicht absorbierenden Materials wiedergibt;
- Fig. 4: die Fig. 1 mit einer Reflexionsschicht zwischen dem rückseitigen Laserspiegel und der Schicht absorbierenden Materials darstellt;
- Fig. 5: die Fig. 4 mit einer elektrischen Isolationsschicht zwischen dem rückseitigen Laserspiegel und der Reflexionsschicht zeigt;
- Fig. 6: die Fig. 5 darstellt, bei die Reihenfolge der elektrische Isolationsschicht und Reflexionsschicht vertauscht wurde;
- Fig. 7: die Fig. 5 mit einer elektrischen Isolationsschicht zwischen der Reflexionsschicht und der Schicht absorbierenden Materials repräsentiert;
- Fig. 8: berechnete Lichtleistungs-Strom-Kennlinien eines Halbleiterlasers mit frontseitig entspiegeltem Laserspiegel (R_{F} = 10 %) und rückseitig verspiegeltem Laserspiegel (R_{R} = 90 %) wiedergibt;
- Fig. 9: an einem rückseitigen Laserspiegel mit R_{R} = 95 % vor und nach der Beschichtung mit einer Schicht absorbierenden Materials gemessene Lichtleistungs-Strom-Kennlinien zeigt, wobei der frontseitige Laserspiegel einen Reflexionskoeffizienten von 20 % aufweist.

### 5. Detaillierte Beschreibung bevorzugter Ausführungsbeispiele

Im Folgenden werden bevorzugte Ausführungsformen der erfindungsgemäßen Vorrichtungen genauer erläutert.

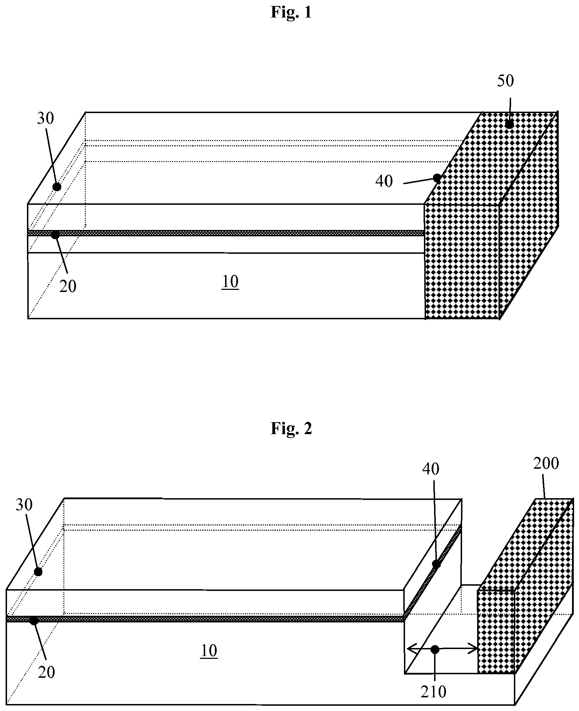

Die Fig. 1 zeigt schematisch die Schichten eines Halbleiterlasers, die zur Erläuterung der erfindungsgemäßen Prinzipien wichtig sind. Auf einem Halbleitersubstrat 10 wird mittels eines Epitaxieprozesses eine Wellenleiterstruktur (in der Fig. 1 nicht dargestellt) abgeschieden, in die eine aktive Schicht 20 eingebettet ist. In der aktiven Schicht 20 wird optische Strahlung in einem Wellenlängenbereich innerhalb der Verstärkungsbandbreite des Materials der aktiven Schicht 20 erzeugt. Die aktive Schicht wird auf der Laservorderseite durch einen frontseitigen Spiegel 30 und auf der gegenüberliegenden Seite durch den rückseitigen Laserspiegel 40 abgeschlossen. Die aktive Schicht 20 muss nicht, wie in Fig. 1 dargestellt, bis zu den Laserspiegeln 30, 40 reichen. Insbesondere muss der Strom, der in die aktive Schicht 20 injiziert wird, nicht über die gesamte Länge zwischen den Laserspiegeln 30 und 40 zugeführt werden.

Neben oder anstatt der Laserspiegel 30 und 40, die einen Fabry-Pérot Resonator bilden, kann der Halbleiterlaser weitere Wellenlängen selektierende Elemente wie etwa eine DFB (distributed feedback) oder eine DBR (distributed Bragg reflection) Struktur aufweisen. Die erfindungsgemäße Schicht absorbierenden Materials, wie auch das nachfolgend beschriebene erfindungsgemäße Absorbermodul können auch für Laserdioden eingesetzt werden, die Licht in Richtung der Schichtfolge abstrahlen, d.h. für sogenannte VCSELs (vertical cavity surface emitting lasers).

Das Materialsystem des Halbleitersubstrats 10 wird durch die zu realisierende Wellenlänge der Laserdiode bestimmt. Die nachfolgend detailliert ausgeführten erfindungsgemäßen Prinzipien können auf alle bekannten Materialsysteme angewandt werden, um Laserdioden herzustellen, die Licht von dem blauen (beispielsweise auf Galliumnitrid-Substraten) bis tief in den infraroten Wellenlängenbereich emittieren. Neben Substraten auf der Basis von III/V Verbindungshalbleitern können die offenbarten Prinzipien auch auf Laserdioden angewendet werden, die auf II/VI Halbleitersubstraten oder anderen geeigneten Substraten aufgebaut sind.

Auf den rückseitigen Laserspiegel 40 wird eine Schicht absorbierenden Materials 50 mit dem Ziel aufgebracht, dass Strahlung, die durch den Laserspiegel 40 in die absorbierende Schicht 50 eindringt, von dem Material dieser Schicht absorbiert und in Wärme umgewandelt wird. Bei Laserdioden mit Fabry-Pérot Resonator darf der Brechungsindex der absorbierenden Schicht 50 nicht mit dem Brechungsindex der aktiven Schicht 20 übereinstimmen, sonst würde der Wirkung des Laserspiegels 40 verlorengehen und die Halbleiterstrahlungsquelle nicht länger als Laserdiode funktionieren. Bei einem großen Zahlenwert des Absorptionskoeffizienten der absorbierenden Schicht 50 reicht bereits eine geringe Schichtdicke aus, um eine vorgegebene Resttransmission zu erreichen. Ein großer Absorptionskoeffizient bedeutet umgekehrt, dass die gesamte Strahlungsleistung in einem kleinen Volumen in Wärme umgewandelt wird.

Die Fig. 2 zeigt den in der Fig. 1 dargestellten Halbleiterlaser bei dem im rückwärtigen Teil die Schichtstruktur - einschließlich der aktiven Schicht 20 - bis auf Teile des Halbleitersubstrats 10 entfernt wurde. Hinter dem rückseitigen Laserspiegel 40 wird in einem Abstand 210 von dem Laserspiegel 40 ein Absorbermodul 200 auf dem Halbleitersubstrat 10 angeordnet. Der Abstand 210 und die Fläche des Absorbermoduls 200 senkrecht zu der Richtung des Lichtstrahls werden dabei so gewählt, dass zumindest 99,9 % der Photonen, die den Laserresonator durch den Laserspiegel 40 verlassen, auf das Absorbermodul 200 treffen. Bei einem kleinen Abstand 210 erfüllt bereits eine kleine dem Laserspiegel 40 zugewandte Fläche des Absorbermoduls 200 diese Forderung. Mit größer werdendem Abstand 210 muss auch die dem Laserspiegel 40 zugewandte Fläche des Absorbermoduls 200 entsprechend anwachsen.

Das Absorbermodul 200 kann mittels eines Expitaxieprozesses auf dem Halbleitersubstrat 10 hergestellt werden. Es ist jedoch auch möglich ein vorgefertigtes Absorbermodul 200 auf dem Halbleitersubstrat 10 bzw. auf einem räumlich vom Halbleitermaterial getrennten Submount zu befestigen, beispielsweise durch Kleben oder Löten. Das Absorbermodul 200 muss nicht - wie in der Fig. 2 dargestellt - eine quaderförmige Form aufweisen. Es sind beliebige Formen des Absorbermoduls einsetzbar. Durch das Anordnen des Absorbermoduls 200 in einem Abstand 210 von dem rückseitigen Laserspiegel 40 kann eine thermische Belastung des Laserspiegels 40 durch ein mögliches Erwärmen des absorbierenden Materials, insbesondere bei großen optischen Leistungen und einem großen Absorptionskoeffizienten vermieden werden.

Als Absorbermaterialien können sowohl für die Schicht absorbierenden Materials der Fig. 1 als auch für das Absorbermodul 200 der Fig. 2 ein Halbleitermaterial oder eine Kombination mehrerer Halbleitermaterialen eingesetzt werden, die in dem Wellenlängenbereich der erzeugten Laserstrahlung absorbieren. Für Wellenlängen der optischen Strahlung, die kleiner al 1 µm sind, kann beispielsweise Silizium zum Einsatz kommen. Halbleiterverbindungen, die aufgrund ihres geringen Bandabstandes Licht größerer Wellenlänge absorbieren können, sind beispielsweise Indiumarsenid und Indiumantimonid.

Absorbierende Materialien können ferner auf der Basis von Kohlenstoff, insbesondere amorphem Kohlenstoff beispielsweise in der Form von Ruß hergestellt werden. Ebenso können Kohlenstoffverbindungen als Ausgangsstoffe für Absorbermaterialien dienen. Des Weiteren können Farben oder Lacke zur Erzeugung absorbierender Schichten für den diskutierten Wellenlängenbereich von etwa 0,5 µm bis etwa 10 µm herangezogen werden.

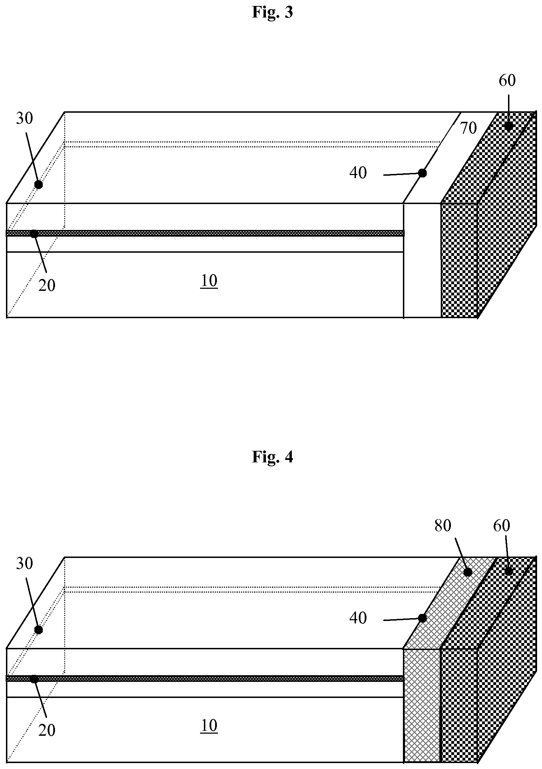

In der Fig. 3 wurde zwischen den Laserspiegel 40 und die Schicht absorbierenden Materials 60 der Fig. 1 eine elektrische Isolationsschicht 70 eingebaut. Diese zusätzliche Schicht übernimmt zwei Aufgaben: Zum einen wird die absorbierende Schicht 60 elektrisch von dem Laserspiegel 40 entkoppelt. Dadurch wird es möglich als Absorbermaterial leitfähige Materialien, wie etwa Metalle, beispielsweise Titan oder eine Mischung mehrerer Metalle zu verwenden. Aufgrund der großen Absorptionskoeffizienten der meisten Metalle in dem Wellenlängenbereich von etwa 0,5 µm bis etwa 10 µm, reichen bereits dünne Schichten im Bereich von einigen 100 nm, um praktisch alle Photonen zu absorbieren. Zum anderen gestattet die Wahl des Materials der elektrischen Isolationsschicht 70 die Brechungsindexdifferenz zwischen dem Halbleitermaterial des Laserspiegels 40 und der Isolationsschicht 70 und damit den Reflexionsfaktor des Laserspiegels 40 definiert einzustellen.

Für das Absorbermodul 200 der Fig. 2 können ebenfalls ein oder mehrere Metalle zur Anwendung kommen.

Die bisher diskutierten Ausführungsbeispiele unterdrücken die Strahlung des rückseitigen Laserspiegels wirksam und vermeiden somit die im zweiten Abschnitt beschriebene Streulichtproblematik. Ein Problem kann jedoch auftreten, wenn der Brechungsindex der absorbierenden Schicht 50 oder der elektrischen Isolationsschicht 70 deutlich größer als 1 ist. Dadurch kann der Reflexionsfaktor des rückseitigen Laserspiegels 40 gegenüber seinem Ausgangswert verringert werden. Die Güte des Laserresonators wird hierdurch verschlechtert und der Anteil der Lichtleistung, die über den rückseitigen Laserspiegel ausgekoppelt wird, steigt an. Eine besonders vorteilhafte Ausführungsform der erfindungsgemäßen Prinzipien kombiniert deshalb eine auf den rückseitigen Laserspiegel 40 aufgebrachte Vergütungsschicht mit einer Schicht absorbierenden Materials 50, 60 hinter der Vergütungsschicht.

Die Fig. 4 zeigt schematisch diese Ausführungsform. Mit der Reflexionsschicht 80, die eine oder mehrere dielektrische Schichten umfassen kann, kann der Reflexionsfaktor des rückseitigen Laserspiegels 40 eingestellt werden. Insbesondere kann, durch eine Vergütung des rückseitigen Laserspiegels 40 mittels der Reflexionsschicht 80, der Reflexionsfaktor des rückseitigen Laserspiegels 40 über seinen ursprünglichen Wert hinaus vergrößert werden. Reflexionsfaktoren im Bereich von 90 % bis 95 % sind durch Aufbringen einer oder mehrerer dielektrischer Schichten erreichbar. Ein großer Reflexionsfaktor der Reflexionsschicht 80 weist zwei Vorteile auf: Einerseits wird die Verlustquelle, die der rückseitige Laserspiegel 40 darstellt, verkleinert. Dies resultiert in einer Steigerung des Wirkungsgrads des Halbleiterlasers. Andererseits muss in der auf die Reflexionsschicht 80 folgenden Schicht absorbierenden Materials 50, 60 weniger Lichtleistung in Wärme transformiert werden. Damit kann bei vorgegebener zulässiger Resttransmission die absorbierende Schicht 50, 60 dünner gemacht werden oder bei unveränderter Dicke der Schicht absorbierenden Materials 50, 60 verringert sich die Anzahl der Photonen, die es schaffen, eine Schicht 50, 60 zu durchdringen.

Die im vorletzten Abschnitt beschriebenen Vorteile einer Reflexionsschicht 80 ergeben sich in gleicher Weise für die Kombination eines Laserspiegels 40, der mit einer Reflexionsschicht 80 versehen ist und dem in der Fig. 2 dargestellten Absorbermodul 200. Die Photonen, die die Reflexionsschicht 80 verlassen, werden nach ihrem Auftreffen auf das Absorbermodul 200 von dem absorbierenden Material des Absorbermoduls 200 in Wärme umgesetzt.

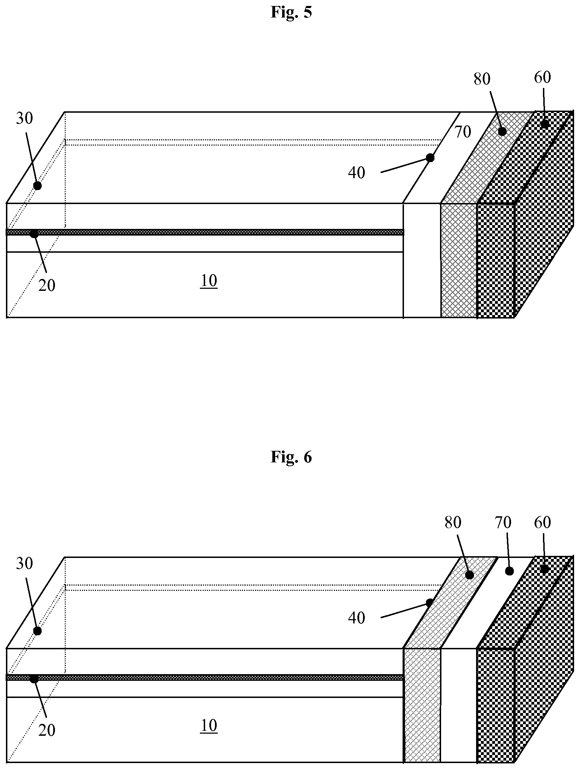

In der Fig. 5 wurde zusätzlich zu der Reflexionsschicht 80 und der Schicht absorbierenden Materials 50, 60 die elektrische Isolationsschicht 70 der Fig. 3 zwischen den Laserspiegel 40 und die Reflexionsschicht 80 eingefügt. Damit kann der Brechungsindexsprung an dem Laserspiegel 40 und an der Reflexionsschicht 80 eingestellt werden. Darüber hinaus ermöglicht die elektrische Isolationsschicht 70 das Maximum der Intensitätsverteilung von dem Laserspiegel 40 in die Isolationsschicht 70 zu verlagern. Dies schützt den rückseitigen Laserspiegel 40 vor Beschädigungen, insbesondere bei großen durch den fronseitigen Laserspiegel 30 ausgekoppelten Lichtleistungen.

In der Fig. 6 wurde die Reihenfolge der beiden Schichten elektrische Isolationsschicht 70 und Reflexionsschicht 80 gegenüber der Fig. 5 vertauscht. Damit wird für die Auswahl der Materialien für die Schicht absorbierenden Materials 50, 60 eine größere Freiheit eröffnet. Insbesondere kann die Schicht absorbierenden Materials 50, 60 ein oder mehrere Metalle aufweisen.

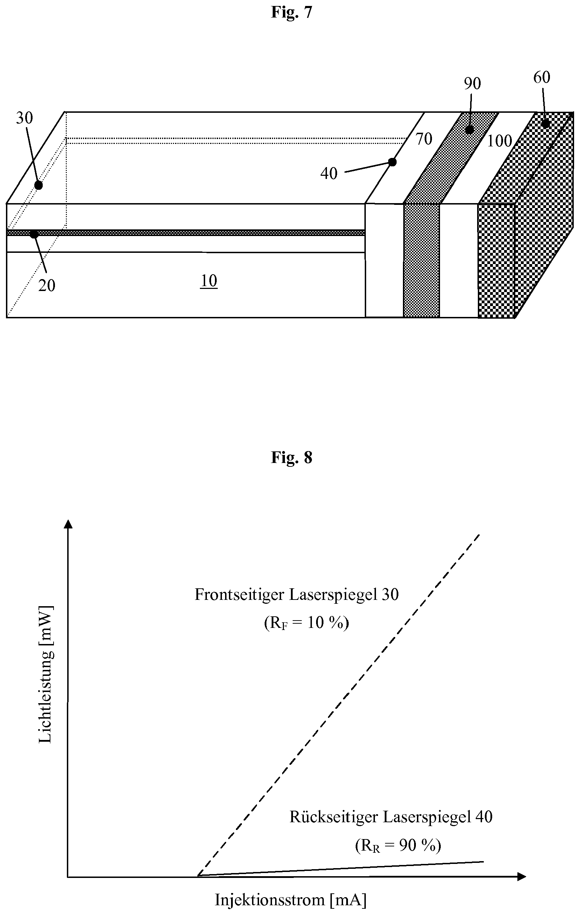

Die Fig. 7 zeigt schematisch die Fig. 5 mit einer zusätzlichen elektrischen Isolationsschicht 100 zwischen der Reflexionsschicht 80 und der Schicht absorbierenden Materials 50, 60. Diese zusätzliche Isolationsschicht 100 entkoppelt die Reflexionsschicht 80 von der Schicht absorbierenden Materials 50, 60. Mit der in der Fig. 7 dargestellten Schichtanordnung wird es möglich sowohl für die Reflexionsschicht 90 wie auch die Schicht absorbierenden Materials 50, 60 einen weiten Bereich von Materialien einzusetzen, insbesondere ein oder mehrere Metalle oder Metallverbindungen. Dies gilt für die Reflexionsschicht 90 genauso wie für die Schicht absorbierenden Materials 60.

Ferner ist es möglich eine Kombination aus einer Schicht absorbierenden Materials 50, 60 und eines Absorbermoduls 200 einzusetzen. Indem nur ein Teil der Lichtleistung in unmittelbarer Nähe des Laserspiegels 40 in Wärme umgesetzt wird, kann für sehr große optische Leistungen die thermische Belastung des Laserspiegels 40 begrenzt werden. Ferner ist es denkbar alle oben diskutierten Schichtfolgen der Schichten: elektrische Isolationsschichten 70, 100, Reflexionsschicht 80 und Schichten absorbierenden Materials 50, 60 mit einem Absorbermodul 200 zu kombinieren.

Durch die Verspiegelung des rückseitigen Laserspiegels 40 sinkt die Lichtleistung, die durch den rückseitigen Laserspiegel 40 austritt, im Vergleich zu der optischen Leistung, die den Laserresonator durch den frontseitigen Laserspiegel 30 verlässt. Durch die Entspiegelung des frontseitigen Laserspiegels 30 bei gleichzeitig verspiegeltem rückseitigem Laserspiegel 40 kann die frontseitig aus dem Laserresonator auskoppelbare Lichtleistung nochmals vergrößert werden.

Die Fig. 8 gibt das berechnete Verhältnis der Lichtleistungs-Strom-Kennlinien eines Halbleiterlasers wieder, dessen frontseitiger Laserspiegel 30 einen Reflexionskoeffizient von 10 % und dessen rückseitiger Laserspiegel 40 einen Reflexionskoeffizient von 90 % aufweist. Die Asymmetrie der frontseitig und rückseitig ausgekoppelten Lichtleistungen liegt im Bereich von etwa 30. Dies bedeutet, dass trotz einer Entspiegelung des frontseitigen Laserspiegels 30 und einer hohen Verspiegelung des rückseitigen Laserspiegels 40 noch immer zwischen 3 % und 4 % der Lichtleistung den Laserresonator durch den rückseitigen Laserspiegel 40 verlassen.

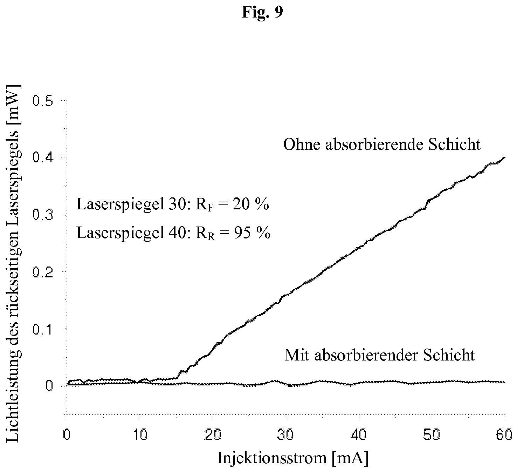

Die Fig. 9 zeigt an dem rückseitigen Laserspiegel 40 gemessene Lichtleistungs-Strom-Kennlinien einer GasAs/AlₓGa₍₁₋ₓ₎As (Galliumarsenid / Aluminiumgalliumarsenid) DFB Laserdiode mit lateraler Kopplung vor und nach dem Aufbringen einer Schicht absorbierenden Materials 60. Zudem weist die Laserdiode eine Entspiegelung des frontseitigen Laserspiegels 30 (R_{F} = 20 %) und eine Verspiegelung des rückseitigen Laserspiegels 40 (R_{R} = 95 %) auf. Dies entspricht der in der Fig. 4 dargestellten Anordnung mit einer zusätzlichen teilweisen Entspiegelung des frontseitigen Laserspiegels 30. In diesem Beispiel umfasst die absorbierende Schicht 60 im Wesentlichen Titan und die Reflexionsschicht 80 umfasst vier Teilschichten in der Abfolge SiO₂/Si/SiO₂/Si beginnend an dem Laserspiegel 40.

Wie der Fig. 9 zu entnehmen ist, kann nach dem Aufbringen der absorbierenden Schicht 60 hinter dem rückseitigen Laserspiegel 40 keine Lichtleistung mehr detektiert werden. Die absorbierende Schicht 60 des rückseitigen Laserspiegels 40 verringert die nach dem Laserspiegel 40 gemessene Steigung der Lichtleistungs-Strom-Kennlinie in diesem Beispiel um mindestens einen Faktor 10.000. Diese Angabe stellt allerdings nur eine Abschätzung dar, da durch die Kombination eines hoch verspiegelten rückseitigen Laserspiegels 40 (R_{R} = 95 %) mit einer Schicht absorbierenden Materials 60 die Steigung der Lichtleistungs-Strom-Kennlinie hinter dem Laserspiegel 40 soweit verringert wird, dass eine experimentelle Bestimmung ihrer Steigung nicht mehr möglich ist.

Die elektrischen Isolationsschichten 70, 100 und die Reflexionsschicht 80 können mittels thermischer Verdampfung, Elektronenstrahlverdampfung oder mittels eines Sputterprozesses auf den rückseitigen Laserspiegel 40 aufgebracht werden. Die Schicht absorbierenden Materials 60 und die Reflexionsschicht 90 können durch thermisches Verdampfen, elektrisches Verdampfen des Materials oder mittels eines Sputterprozesses auf den rückseitigen Laserspiegel 40 aufgebracht werden.

Das Absorbermodul 200 kann aus den oben beschriebenen Materialien aufgebaut werden. Es ist jedoch auch möglich für das Absorbermodul einen Grundkörper aus einem beliebigen Material, etwa einen Glas- oder Kunststoffkörper zu verwenden und zumindest die dem Laserspiegel 40 zugewandte Seite mit Hilfe eines der im vorhergehenden Abschnitt erläuterten Verfahrens mit einer Schicht absorbierenden Materials 50, 60 zu versehen. Ebenso kann die gesamte Oberfläche des Grundkörpers mit einer Schicht absorbierenden Materials überzogen werden. Schließlich sind zum Aufbringen einer Schicht absorbierenden Materials auf den Grundkörper weitere Prozesse einsetzbar, so kann beispielsweise die Oberfläche des Grundkörpers mit einem absorbierenden Materials besprüht werden oder der Grundkörper wird in ein Tauchbad eingebracht, das das absorbierende Material enthält.

In der nachfolgenden Tabelle werden beispielhaft die Beschichtungsdaten des rückseitigen Laserspiegels 40 des in der Fig. 9 verwendeten Halbleiterlasers zusammengestellt.

**Tabelle 1: Daten der der Reflexionsschicht 80 und der Schicht absorbierenden Materials 60**

| Funktion | Dicke [nm] | Material |
|---|---|---|
| Reflexionsschicht 80 | 270 | SiO₂ |
| | 110 | Si |
| | 270 | SiO₂ |
| | 110 | Si |
| Schicht absorbierenden Materials 60 | 500 | Titan |

## Patentansprüche

1. Halbleiterlaser, aufweisend:
a. zumindest ein Halbleitersubstrat (10);
b. zumindest eine auf dem Halbleitersubstrat (10) angeordnete aktive Schicht (20);
c. einen frontseitigen Laserspiegel (30), der an einem ersten Ende der aktiven Schicht angeordnet ist und durch den ein erster Teil der in der aktiven Schicht (20) erzeugten Strahlung austritt; und
d. einen rückseitigen Laserspiegel (40), der an einem zweiten Ende der aktiven Schicht (20) angeordnet ist, das dem ersten Ende gegenüber liegt und durch den ein zweiter Teil der in der aktiven Schicht (20) erzeugten Strahlung austritt, wobei der rückseitige Laserspiegel (40) mit einer Schicht absorbierenden Materials (50, 60) versehen ist, die geeignet ist, eine Steigung der Lichtleistungs-Strom-Kennlinie für Strahlung, die durch den rückseitigen Laserspiegel (40) austritt, relativ zu einem rückseitigen Laserspiegel (40) ohne Schicht absorbierenden Materials (50, 60) zu verringern;
wobei eine Schichtdicke der Schicht absorbierenden Materials (50, 60) derart ausgebildet ist, die Steigung der Lichtleistungs-Strom-Kennlinie um einen Faktor 10000 zu verringern; und
wobei zwischen dem rückseitigen Laserspiegel (40) und der Schicht absorbierenden Materials (50, 60) zumindest eine Reflexionsschicht (80) angeordnet ist, wobei der Reflexionskoeffizient der Reflexionsschicht (80, 90) in dem emittierten Wellenlängenbereich ≥ 90 % beträgt.

2. Halbleiterlaser, aufweisend:
a. zumindest ein Halbleitersubstrat (10);
b. zumindest eine auf dem Halbleitersubstrat (10) angeordnete aktive Schicht (20);
c. einen frontseitigen Laserspiegel (30), der an einem ersten Ende der aktiven Schicht angeordnet ist und durch den ein erster Teil der in der aktiven Schicht (20) erzeugten Strahlung austritt;
c. einen rückseitigen Laserspiegel (40), der an einem zweiten Ende der aktiven Schicht (20) angeordnet ist, das dem ersten Ende gegenüber liegt und durch den ein zweiter Teil der in der aktiven Schicht (20) erzeugten Strahlung austritt; und
d. ein auf dem Halbleitersubstrat (10) angeordnetes Absorbermodul (200), das in einem Abstand (210) von dem rückseitigen Laserspiegel (40) in Richtung der erzeugen Strahlung angeordnet ist und das geeignet ist hinter dem Absorbermodul (200) eine Steigung der Lichtleistungs-Strom-Kennlinie für Strahlung, die durch den rückseitigen Laserspiegel (40) austritt, relativ zu der Steigung der Lichtleistungs-Strom-Kennlinie hinter dem rückseitigen Laserspiegel (40) zu verringern;
wobei eine Dicke des Absorbermoduls (200) derart ausgebildet ist, die Steigung der Lichtleistungs-Strom-Kennlinie um einen Faktor 10000 zu verringern und
wobei zwischen dem rückseitigen Laserspiegel (40) und der dem Absorbermodul (200) zumindest eine Reflexionsschicht (80) angeordnet ist und wobei der Reflexionskoeffizient der Reflexionsschicht (80, 90) in dem emittierten Wellenlängenbereich ≥ 90 % beträgt.

3. Halbleiterlaser gemäß einem der Ansprüche 1 oder 2, wobei die Schicht absorbierenden Materials (50) und / oder das Absorbermodul (200) ein oder mehrere Halbleitermaterialien und / oder Halbleiterverbindungen, die in dem Wellenlängenbereich der erzeugten Strahlung absorbieren, Kohlenstoff oder Kohlenstoffverbindungen und / oder einen oder mehrere absorbierende Lacke umfassen.

4. Halbleiterlaser gemäß einem der vorhergehenden Ansprüche, wobei zwischen dem rückseitigen Laserspiegel (40) und der Schicht absorbierenden Materials (50, 60) zumindest eine elektrische Isolationsschicht (70) angeordnet ist.

5. Halbleiterlaser gemäß Anspruch 4, wobei die Schicht absorbierenden Materials (60) ein oder mehrere Metalle umfasst, insbesondere Titan.

6. Halbleiterlaser gemäß Anspruch 2, wobei das Absorbermodul (200) ein oder mehrere Metalle umfasst, insbesondere Titan.

7. Halbleiterlaser gemäß einem der vorhergehenden Ansprüche, wobei die Reflexionsschicht (80) zumindest ein Metalloxid, insbesondere Aluminiumoxid, Titanoxid und / oder Magnesiumoxid umfasst.

8. Halbleiterlaser gemäß einem vorhergehenden der Ansprüche, wobei die Reflexionsschicht (80) zumindest ein Halbleitermaterial, beispielsweise Silizium, eine Halbleiterverbindung, beispielsweise Siliziumdioxid und / oder eine Schichtstruktur aus einem Halbleitermaterial und einer Halbleiterverbindung umfasst.

9. Halbleiterlaser gemäß einem der vorhergehenden Ansprüche, wobei zwischen dem rückseitigen Laserspiegel (40) und der Reflexionsschicht (80) zumindest eine elektrische Isolationsschicht (70) angeordnet ist.

10. Halbleiterlaser gemäß einem der vorhergehenden Ansprüche, wobei zwischen dem rückseitigen Laserspiegel (40) und der elektrischen Isolationsschicht (70) zumindest eine Reflexionsschicht (80) angeordnet ist.

11. Halbleiterlaser gemäß einem der Ansprüche 1 oder 3 - 10, wobei zwischen der Reflexionsschicht (80) und der Schicht absorbierenden Materials (50, 60) zumindest eine elektrische Isolationsschicht (100) angeordnet ist.

12. Halbleiterlaser gemäß Anspruch 11, wobei eine Reflexionsschicht (90) zumindest ein Metall umfasst, insbesondere Gold oder Silber.

13. Halbleiterlaser gemäß Anspruch 2, wobei das Absorbermodul (200), das in einem Abstand (210) hinter dem rückseitigen Laserspiegel (40) angeordnet ist, derart ausgebildet ist damit zumindest 99,9 % der durch den rückseitigenLaserspiegel (40) austretenden Lichtintensität auf das Absorbermodul (200) trifft.

14. Halbleiterlaser gemäß Anspruch 2, wobei das Absorbermodul (200) an zumindest einer Seite, die dem rückseitigen Laserspiegel (40) zugewandt ist, mit einer Schicht absorbierenden Materials (50, 60) versehen ist.

15. Halbleiterlaser gemäß Anspruch 2, wobei eine gesamte Oberfläche des Absorbermoduls (200) mit einer Schicht absorbierenden Materials (50, 60) versehen ist.

16. Halbleiterlaser gemäß Anspruch 2, wobei das Absorbermodul (200) mittels eines Epitaxieprozesses auf dem Halbleitersubstrat (10) hergestellt wird.

17. Halbleiterlaser gemäß Anspruch 2, wobei das Absorbermodul (200) durch Kleben oder Löten auf dem Halbleitersubstrat (10) befestigt wird.

18. Sensorvorrichtung zum Bestimmen von Gaskonzentrationen aufweisend einen Halbleiterlaser gemäß einem der vorangehenden Ansprüche.

## Claims

1. A semiconductor laser, comprising:
a. at least one semiconductor substrate (10);
b. at least one active layer (20) arranged on the semiconductor substrate (10);
c. a front laser mirror (30) which is arranged at a first end of the active layer and through which a first part of the radiation generated in the active layer (20) emerges;
d. a one rear laser mirror (40) which is arranged at a second end of the active layer (20) and lying opposite the first end and through which a second part of the radiation generated in the active layer (20) emerges, wherein the rear laser mirror (40) is provided with a layer of absorbing material (50, 60), which is suitable for reducing a gradient of the luminous-power/current characteristic for radiation emerging through the rear laser mirror (40), relative to a rear laser mirror (40) without a layer of absorbing material (50, 60);
wherein a layer thickness of the layer of absorbing material (50, 60) is adapted to reduce the gradient of the luminous-power/current characteristic by a factor of 10,000; and
wherein at least one reflection layer (80) is arranged between the rear laser mirror (40) and the layer of absorbing material (50, 60), and wherein the reflection coefficient of the reflection layer (80) is ≥ 90% in the emitted wavelength range.

2. A semiconductor laser, comprising:
a. at least one semiconductor substrate (10);
b. at least one active layer (20) arranged on the semiconductor substrate (10);
c. a front laser mirror (30) which is arranged at a first end of the active layer and through which a first part of the radiation generated in the active layer (20) emerges;
c. a rear laser mirror (40) which is arranged at a second end of the active layer (20) and lying opposite the first end and, through which a second part of the radiation generated in the active layer (20) emerges; and
d. an absorber module (200) arranged on the semiconductor substrate (10), which is arranged at a distance (210) from the rear laser mirror (40) in the direction of the generated radiation and which is suitable for reducing a gradient of the luminous power/current characteristic behind the absorber module (200) for radiation which emerges through the rear laser mirror (40) relative to the gradient of the luminous-power/current characteristic behind the rear laser mirror (40),
wherein a thickness of the absorber module (200) is adapted to reduce the gradient of the luminous-power/current characteristic by a factor of 10,000; and
wherein at least one reflection layer (80) is arranged between the rear laser mirror (40) and the absorber module (200), and wherein the reflection coefficient of the reflection layer (80, 90) is ≥ 90% in the emitted wavelength range.

3. The semiconductor laser according to claim 1 or 2, wherein the layer of absorbing material (50) and / or the absorber module (200), one or more semiconductor materials and / or semiconductor compounds which absorb in the wavelength range of the generated radiation, comprise carbon or carbon compounds and / or one or more absorbent lacquers.

4. The semiconductor laser according to any one of the preceding claims, wherein at least one electrical insulation layer (70) is arranged between the rear laser mirror (40) and the layer of absorbing material (50, 60).

5. The semiconductor laser according to claim 4, wherein the layer of absorbing material (60) comprises one or more metals, in particular titanium.

6. The semiconductor laser according to claim 2, wherein the layer of absorbing material (60) comprises one or more metals, in particular titanium.

7. The semiconductor laser according to any one of the preceding claims, wherein the reflection layer (80) comprises at least one metal oxide, in particular aluminium oxide, titanium oxide and /or magnesium oxide.

8. The semiconductor laser according to any one of the preceding claims, wherein the reflection layer (80) comprises at least one semiconductor material, for example silicon, a semiconductor compound, for example silicon dioxide, and / or a layer structure made of a semiconductor material and a semiconductor compound.

9. The semiconductor laser according to any one of the preceding claims, wherein at least one electrical isolation layer (70) is arranged between the rear laser mirror (40) and the reflection layer (80).

10. The semiconductor laser according to any one of the preceding claims, wherein at least one reflection layer (80) is arranged between the rear laser mirror (40) and the electrical insulation layer (70).

11. The semiconductor laser according to any one of claims 1 or 3 - 10, wherein at least one electrical insulation layer (100) is arranged between the reflection layer (80) and the layer of absorbing material (50, 60).

12. The semiconductor laser according to claim 11, wherein a reflection layer (90) comprises at least one metal, in particular gold or silver.

13. The semiconductor laser according to claim 2, wherein the absorber module (200), which is arranged at a distance (210) behind the rear laser mirror (40), is adapted such that at least 99.9% of the light intensity emerging through the rear laser mirror (40) is incident on the absorber module (200).

14. The semiconductor laser according to claim 2, wherein at least one side of the absorber module (200) facing to the laser mirror (40) is provided with a layer of absorbing material (50, 60).

15. The semiconductor laser according to claim 2, wherein an entire surface of the absorber module (200) is provided with a layer of absorbing material (50, 60).

16. The semiconductor laser according to claim 2, wherein the absorber module (200) is fabricated on the semiconductor substrate (10) using an epitaxial process.

17. The semiconductor laser according to claim 2, wherein the absorber module (200) is fixed on the semiconductor substrate (10) by gluing or soldering.

18. A sensor device for determining gas concentrations comprising a semiconductor laser according to any one of the preceding claims.

## Revendications

1. Laser à semi-conducteur comprenant :
a. au moins un substrat semi-conducteur (10) ;
b. au moins une couche active (20) disposée sur le substrat semi-conducteur (10) ;
c. un miroir laser avant (30) qui est disposé à une première extrémité de la couche active et à travers lequel sort une première partie du rayonnement généré dans la couche active (20) ; et
d. un miroir laser arrière (40) qui est disposé à une seconde extrémité de la couche active (20), laquelle extrémité se trouve à l'opposé de la première extrémité, et à travers lequel sort une seconde partie du rayonnement généré dans la couche active (20), le miroir laser arrière (40) étant muni d'une couche de matériau absorbant (50, 60) qui est apte à réduire un accroissement de la courbe caractéristique puissance lumineuse-courant pour le rayonnement qui sort à travers le miroir laser arrière (40) par rapport à un miroir laser arrière (40) sans couche de matériau absorbant (50, 60) ;
dans lequel une épaisseur de couche de la couche de matériau absorbant (50, 60) est conçue pour réduire d'un facteur 10000 l'accroissement de la courbe caractéristique puissance lumineuse-courant ; et
dans lequel au moins une couche de réflexion (80) est disposée entre le miroir laser arrière (40) et la couche de matériau absorbant (50, 60), le coefficient de réflexion de la couche de réflexion (80, 90) dans la plage de longueurs d'onde émise étant ≥ 90 %.

2. Laser à semi-conducteur comprenant :
a. au moins un substrat semi-conducteur (10) ;
b. au moins une couche active (20) disposée sur le substrat semi-conducteur (10) ;
c. un miroir laser avant (30) qui est disposé à une première extrémité de la couche active et à travers lequel sort une première partie du rayonnement généré dans la couche active (20) ; et
d. un miroir laser arrière (40) qui est disposé à une seconde extrémité de la couche active (20), laquelle extrémité se trouve à l'opposé de la première extrémité, et à travers lequel sort une seconde partie du rayonnement généré dans la couche active (20) ; et
e. un module absorbeur (200) qui est disposé sur le substrat semi-conducteur (10) et qui est disposé à une distance (210) du miroir laser arrière (40) dans la direction du rayonnement généré et qui est apte à réduire, derrière le module absorbeur (200), un accroissement de la courbe caractéristique puissance lumineuse-courant pour le rayonnement qui sort à travers le miroir laser arrière (40) par rapport à l'accroissement de la courbe caractéristique puissance lumineuse-courant derrière le miroir laser arrière (40) ;
dans lequel une épaisseur du module absorbeur (200) est conçue de façon à réduire d'un facteur 10000 l'accroissement de la courbe caractéristique puissance lumineuse-courant, et
dans lequel au moins une couche de réflexion (80) est disposée entre le miroir laser arrière (40) et le module absorbeur (200), le coefficient de réflexion de la couche de réflexion (80, 90) étant ≥ 90 % dans la plage de longueurs d'onde émise.

3. Laser à semi-conducteur selon l'une des revendications 1 ou 2, dans lequel la couche de matériau absorbant (50) et/ou le module absorbeur (200) incluent un ou plusieurs matériaux semi-conducteurs et/ou composés semi-conducteurs absorbant dans la plage de longueurs d'onde du rayonnement généré, du carbone ou des composés de carbone et/ou un ou plusieurs vernis absorbants.

4. Laser à semi-conducteur selon l'une des revendications précédentes, dans lequel au moins une couche d'isolation électrique (70) est disposée entre le miroir laser arrière (40) et la couche de matériau absorbant (50, 60).

5. Laser à semi-conducteur selon la revendication 4, dans lequel la couche de matériau absorbant (60) inclut un ou plusieurs métaux, en particulier du titane.

6. Laser à semi-conducteur selon la revendication 2, dans lequel le module absorbeur (200) inclut un ou plusieurs métaux, en particulier du titane.

7. Laser à semi-conducteur selon l'une des revendications précédentes, dans lequel la couche de réflexion (80) inclut au moins un oxyde métallique, en particulier de l'oxyde d'aluminium, de l'oxyde de titane et/ou de l'oxyde de magnésium.

8. Laser à semi-conducteur selon l'une des revendications précédentes, dans lequel la couche de réflexion (80) inclut au moins un matériau semi-conducteur, par exemple du silicium, un composé semi-conducteur, par exemple du dioxyde de silicium et/ou une structure en couches constituée d'un matériau semi-conducteur et d'un composé semi-conducteur.

9. Laser à semi-conducteur selon l'une des revendications précédentes, dans lequel au moins une couche d'isolation électrique (70) est disposée entre le miroir laser arrière (40) et la couche de réflexion (80).

10. Laser à semi-conducteur selon l'une des revendications précédentes, dans lequel au moins une couche de réflexion (80) est disposée entre le miroir laser arrière (40) et la couche d'isolation électrique (70).

11. Laser à semi-conducteur selon l'une des revendications 1 ou 3 à 10, dans lequel au moins une couche d'isolation électrique (100) est disposée entre la couche de réflexion (80) et la couche de matériau absorbant (50, 60).

12. Laser à semi-conducteur selon la revendication 11, dans lequel une couche de réflexion (90) inclut au moins un métal, en particulier de l'or ou de l'argent.

13. Laser à semi-conducteur selon la revendication 2, dans lequel le module absorbeur (200), qui est disposé à une distance (210) derrière le miroir laser arrière (40), est conçu afin qu'au moins 99,9 % de l'intensité lumineuse sortant à travers le miroir laser arrière (40) frappe le module absorbeur (200).

14. Laser à semi-conducteur selon la revendication 2, dans lequel le module absorbeur (200) est muni d'une couche de matériau absorbant (50, 60) sur au moins un côté tourné vers le miroir laser arrière (40).

15. Laser à semi-conducteur selon la revendication 2, dans lequel une totalité de la surface du module absorbeur (200) est munie d'une couche de matériau absorbant (50, 60).

16. Laser à semi-conducteur selon la revendication 2, dans lequel le module absorbeur (200) est réalisé sur le substrat semi-conducteur (10) par un processus d'épitaxie.

17. Laser à semi-conducteur selon la revendication 2, dans lequel le module absorbeur (200) est fixé au substrat semi-conducteur (10) par collage ou brasage.

18. Dispositif de capteur pour déterminer des concentrations de gaz, comprenant un laser à semi-conducteur selon l'une des revendications précédentes.
